# EUROPÄISCHE PATENTANMELDUNG

(11) **EP 0 770 880 A2**
(43) Veröffentlichungstag der Anmeldung: **02.05.1997**
(21) Anmeldenummer: 96116439.9
(22) Anmeldetag: 14.10.1996
(51) Int. Cl.: G01R 31/06

(54) **Vorrichtung zur Ermittlung von Isolationsschäden an Drähten**

(30) Priorität: 26.10.1995 DE 19539926
(71) Anmelder: SIEMENS AKTIENGESELLSCHAFT, 80333 München (DE)
(72) Erfinder: Tapprich, Rolf, Dipl.-Ing. (FH), 97218 Gerbrunn (DE); Schäfer, Günther, Dipl.-Ing. (FH), 97355 Kleinlangheim (DE)

(57) **Zusammenfassung**

Isolationsschäden können bereits beim Wickeln z.B. einer Motorwicklung dadurch sicher erkannt werden, daß eine Prüfspannung (+;-) zwischen einem abisolierten freien Ende (E1 bzw.E2) der zu wickelnden Drähte (D1;D2) und einer Massepotential-Kontaktstelle (N) der Wickelvorrichtung (W) gelegt wird; ein Isolationsschaden ist, z.B. aufgrund eines dadurch verursachten Stromflusses in einem Prüfstromkreis, in einer Auswertevorrichtung (AW) erkennbar.

## Beschreibung

Die Erfindung bezieht sich auf eine Vorrichtung zur Ermittlung von Isolationsschäden an mittels einer Wickelvorrichtung gewickelten isolierten Drähten, insbesondere lackisolierten Motorwicklungsdrähten gemäß Patentanspruch 1.

Beispielsweise beim Einbringen von isolierten Spulenwicklungsdrähten, insbesondere lackisolierten Kupferdrähten, in Statorpakete bzw. Läuferkerne eines Elektromotors mittels an sich bekannter Wickelvorrichtungen (Flyer) besteht die Gefahr, daß die Isolation - wenn nicht schon bei Anlieferung schadhaft - durch die Einziehwerkzeuge bzw. Wickelbacken oder auch durch das in der Wickelvorrichtung aufgenommene zu bewickelnde Motorpaketteil beschädigt wird. Derartige Isolationsfehler werden bei üblichen Fertigungsverfahren erst bei Prüfung der fertiggewickelten Bauteile erkannt oder bleiben deswegen überhaupt unentdeckt, weil die isolationsgeschädigten Stellen von unbeschädigten isolierten Spulendrahtteilen bedeckt werden und somit nicht zu einem direkten unmittelbaren Windungsschluß zwischen zufällig benachbarten Schadstellen führen. Solche Isolationsschäden sind jedoch um so gefährlicher, da sie erst nach Betriebseinsatz des Motors, z.B. durch aufliegenden Abrieb der Bürsten eines Kommutatormotors, zum Windungsschluß zwischen dadurch überbrückten Isolationsfehlstellen bzw. zum Körperschluß mit Motormasseteilen zu einem Motorausfall führen können. Dies bedeutet insbesondere bei sicherheitsrelevanten Motoren, z.B. bei Antriebsmotoren für ABS-Systemen in Kraftfahrzeugen, ein erhebliches Qualitätsrisiko.

Bisher wurde versucht, solchen Qualitätsrisiken durch Prüfungen auf Windungs- bzw. Körperschluß an den bereits gewickelten Bauteilen vor deren Endmontage bzw. Ausliefung vorzubeugen. Mit derartigen Prüfungen können jedoch nur Fehlstellen in der Drahtisolierung erkannt werden, wenn zufällig zwei Fehlstellen benachbarter Drähte unter Kontaktgabe zusammenfallen oder an mit Massepotential verbundenen leitenden Teilen des Bauteils anliegen. Latente Fehlstellen, die erst im Betrieb zu Motorausfällen führen können, sind auf diese Weise überhaupt nicht detektierbar.

Es ist daher Aufgabe vorliegender Erfindung, mit einfachen Mitteln Isolationsschäden an in Bauteile eingewickelten isolierten Drähten in jedem Fall und bei Minimierung von Ausschuß erkennen zu können.

Die Lösung dieser Aufgabe gelingt durch eine Vorrichtung gemäß Hauptanspruch vorliegender Erfindung; vorteilhafte Ausgestaltungen der Erfindung sind jeweils Gegenstand der Unteransprüche.

Durch eine einfache Nachrüstung der an sich vorhandenen Wickelvorrichtung durch einen einfachen äußeren Anschluß einer Prüfspannung an Massepotential führende Kontaktstellen der Wickelvorrichtung einerseits bzw. an, insbesondere bei einem Spulenmagazin, frei zugänglichen Wicklungsenden der zu wickelnden Drähte ist ein Isolationsschaden aufgrund des durch die an sich unerwünschte elektrische Kontaktgabe zwischen den abisolierten freien Enden der Spulenwicklung einerseits und der Massekontaktstelle der Wickelvorrichtung andererseits fließenden Fehlstromes in der Auswertevorrichtung in jedem Fall sicher detektierbar.

Zweckmäßigerweise wird als Prüfspannung eine Gleichspannung in der Größenordnung zwischen 12 - 30 Volt und als Auswertevorrichtung ein elektronischer Schalter, insbesondere ein hochohmiger Transistorschalter, vorgesehen, der bei einem im Fehlerfall fließenden Fehlstrom den elektronischen Schalter betätigt, insbesondere den Transistor durchschaltet und dadurch z.B. eine Anzeigevorrichtung bzw. eine Unterbrechung des Wickelvorganges auslöst.

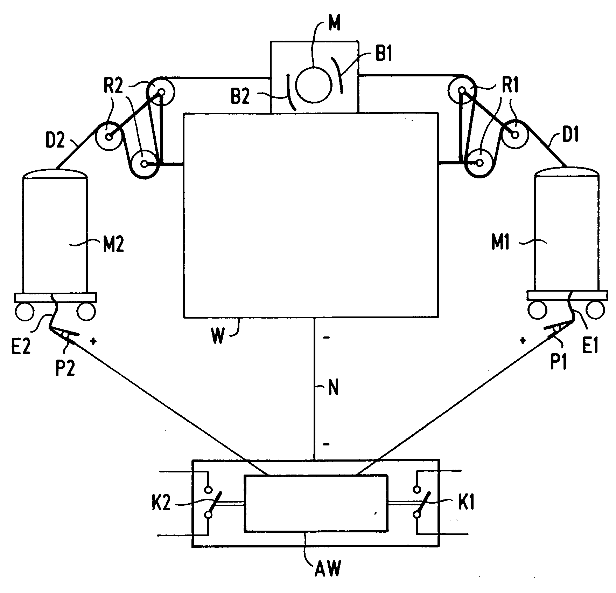

Die Erfindung sowie weitere vorteilhafte Ausgestaltungen der Erfindung gemäß Merkmalen der Unteransprüche werden im folgenden anhand einer schematischen Darstellung eines Ausführungsbeispiels in der Zeichnung näher erläutert.

Die Zeichnung zeigt eine Wickelvorrichtung W mit einem von dieser gehaltenen Statorkern bzw. Rotorkern eines Elektromotors M; als isolierte Drähte D1 bzw.D2 werden lackisolierte Spulenwicklungsdrähte aus einem Magazin M1 bzw.M2 über Führungsrollen R1 bzw.R2 und Wickelbacken B1 bzw.B2 z.B. in die Nuten des Statorkerns bzw. des Rotorkerns des Elektromotors M eingewickelt. Sowohl die Führungsrollen R1 bzw.R2 als auch die Wickelbacken B1 bzw.B2 sowie die Halterung des Elektromotors M in der Wickelvorrichtung W sind üblicherweise derart ausgebildet, daß bei einem Isolationsschaden der dann in diesem Bereich direkt zugängliche Draht auf gleichem Potential wie das Gegenkontaktteil eines ebenfalls isolationsgeschädigten benachbarten Drahtes oder der Wickelvorrichtung oder des Motorteils liegt.

Erfindungsgemäß ist nunmehr jeweils zwischen den freien, üblicherweise aus den Wickelmagazinen M1 bzw.M2 heraushängenden bzw. frei zugänglichen einen freien Wicklungsende E1 bzw.E2 der Drähte D1 bzw.D2 einerseits und einer Massepotential-Kontaktstelle N der Wickelvorrichtung W andererseits als Prüfspannung ein Gleichspannungspotential +;- von vorzugsweise ca. 12 - 30 Volt zwischen einer abisolierten Kontaktstelle P1 bzw.P2 als Pluspol und eine Massepotential-Kontaktstelle N als Negativpol gelegt.

Bei einem Isolationsschaden wird aufgrund der dann gegebenen direkten elektrischen Kontaktgabe zwischen dem im Bereich des Isolationsschadens blanken Drahtes D1 bzw.D2 und dem kontaktierenden Teil der Wickelvorrichtung W bzw. eines zweiten isolationsgeschädigten Drahtes ein Strom über die Auswertevorrichtung AW fließen, der z.B. zu einem Durchschalten des zweckmäßigerweise in der Auswertevorrichtung AW vorgesehenen hochohmigen Transistorschalters führt und der seinerseits eine Betätigung von in der Auswertevorrichtung AW potentialfrei gehaltenen Schaltkontakten R1 bzw.R2 auslöst, durch die eine Anzeigevorrichtung, z.B. eine Signallampe, betätigt oder der Wickelvorgang durch Stillsetzen der Wickelvorrichtung unterbrochen werden kann. In besonders einfacher Weise ist die Auswertevorrichtung AW, die auch die Prüfspannung +;- liefert, lediglich über flexible anklammerbare Verbindungen jeweils mit den freien Wicklungsenden E1 bzw.E2, z.B. jeweils nach einem Wechsel der Wickelmagazine M1 bzw.M2, verbindabr.

Es dürfte ersichtlich sein, daß durch die erfindungsgemäße Vorrichtung in aufwandsarmer, insbesondere auch einfach nachrüstbarer Weise sowohl Fehlerstellen der Isolation, insbesondere in der Lackisolation eines Spulenwicklungsdrahtes, als auch Beschädigungen während des Wickelvorganges erkannt und somit auch ansonsten erst im späteren Betriebseinsatz sich auswirkende Schäden durch Windungsschlüsse bzw. Körperschlüsse vorab erkennbar und somit vermeidbar sind.

## Patentansprüche

1. Vorrichtung zur Ermittlung von Isolationsschäden an mittels einer Wickelvorrichtung (W) gewickelten isolierten Drähten (D1 bzw.D2), insbesondere lackisolierten Motorwicklungsdrähten, mit einer Prüfspannung (+;-) zwischen zumindest einer abisolierten Kontaktstelle (P1 bzw.P2) des zu wickelnden isolierten Drahtes (D1 bzw.D2) einerseits und einer Massepotential-Kontaktstelle (N) der Wickelvorrichtung (W) andererseits sowie mit einer Auswertevorrichtung (AW) zur Erkennung einer elektrischen Kontaktgabe zwischen der Kontaktstelle (P1 bzw.P2) des isolierten Drahtes (D1 bzw.D2) und der Massepotential-Kontaktstelle (N) der Wickelvorrichtung (W).

2. Vorrichtung nach dem vorhergehenden Anspruch mit einer abisolierten Kontaktstelle (P1 bzw.P2) im Bereich des freien Endes (E1 bzw.E2) des zu wickelnden Drahtes (D1 bzw.D2).

3. Vorrichtung nach zumindest einem der vorhergehenden Ansprüche mit einem Gleichspannungspotential als Prüfspannung (+;-), insbesondere von ca. 12 - 30 V, zwischen der abisolierten Kontaktstelle (P1 bzw.P2) des Drahtes (D1 bzw.D2) einerseits und der Massepotential-Kontaktstelle (N) der Wickelvorrichtung (W) andererseits.

4. Vorrichtung nach zumindest einem der vorhergehenden Ansprüche mit einer elektronischen Auswertevorrichtung (AW).

5. Vorrichtung nach dem vorhergehenden Anspruch mit einer Auswertevorrichtung (AW) in Form eines hochohmigen, an die Prüfspannung (+;-) angeschlossenen Transistorsschalters.

6. Vorrichtung nach zumindest einem der vorhergehenden Ansprüche mit einer abisolierten Kontaktstelle (P1 bzw.P2) am jeweils freien Wicklungsende (E1 bzw.E2) eines Drahtmagazins (M1 bzw.M2).

7. Vorrichtung nach Anspruch 6 mit einem Drahtmagazin (M1 bzw.M2) mit einem Spulenwicklungsdraht, insbesondere einem lackisolierten Kupferwicklungsdraht, zum Wickeln einer Statorwicklung bzw. Rotorwicklung eines Elektromotors (M).
